Europäisches Patentamt

European Patent Office

Office européen des brevets

(11) Veröffentlichungsnummer: **0 192 269**
**A1**

(12) # EUROPÄISCHE PATENTANMELDUNG

(21) Anmeldenummer: 86102266.3

(22) Anmeldetag: 21.02.86

(51) Int. Cl.⁴: **H01L 21/90** , H01L 23/52

(30) Priorität: 22.02.85 DE 3506356

(43) Veröffentlichungstag der Anmeldung:
27.08.86 Patentblatt 86/35

(84) Benannte Vertragsstaaten:
BE DE FR GB

(71) Anmelder: **Siemens Aktiengesellschaft Berlin und München**
**Wittelsbacherplatz 2**
**D-8000 München 2(DE)**

(72) Erfinder: **Beil, Gerhard, Dipl.-Chem.**
**Johann-Sebastian-Bach 12**
**D-8058 Erding(DE)**
Erfinder: **Pichler, Alfred, Ing. grad.**
**Bert-Brecht-Weg 4**
**D-8031 Gernlinden(DE)**
Erfinder: **Pachonik, Horst, Dipl.-Phys.**
**Lindenring 135**
**D-8020 Taufkirchen(DE)**
Erfinder: **Plehnert, Kurt**
**Tannenstrasse 8**
**D-8023 Pullach(DE)**

(54) **Elektrische Isolation und Einebnung von strukturierten Oberflächen.**

(57) In mikroelektronischen Schaltungen ist es oft erforderlich, mehrere Strukturebenen übereinander anzuordnen. Das setzt voraus, daß die einzelnen Strukturen gut voneinander isoliert sind. Gleichzeitig soll aber die aufzubringende Schicht in ihren Strukturkanten einen definierten Flankenwinkel (zum Beispiel 40° - 60°) aufweisen. Das löst die Erfindung durch einen zweistufigen Umhüllungsprozeß, wobei zuerst ein Polymer aufgebracht wird, das die Kanten gut umhüllt, und anschließend mit einem gute Einebnungseigenschaften aufweisenden Fotolack abgedeckt wird.

## FIG 8

EP 0 192 269 A1

Elektrische Isolation und Einebnung von strukturierten Oberflächen.

Die Erfindung betrifft ein Verfahren zur elektrischen Isolation und Einebnung von strukturierten, vorzugsweise leitenden Oberflächen.

In mikroelektronischen Schaltungen ist es oft erforderlich, mehrere Strukturebenen übereinander anzuordnen. Das setzt voraus, daß die einzelnen Strukturen voneinander gut isoliert sind. Gleichzeitig sollen an den unteren Strukturen scharfe Kanten vermieden werden.

Bisher ist es bekannt, für diesen Zweck Fotolack zu verwenden. Das hat jedoch den Nachteil, daß die Kantenbedeckung nicht ausreichend erfolgt. Eine gute Stufenbedeckung von tieferliegenden Strukturen ist wegen der Isolationswirkung nötig. Die Einebnung von Strukturunebenheiten mit vorgegebener Schichtdicke muß in einem möglichst hohen Maße (Einebnungsgrad ≧ 90 %) erfolgen.

Der Erfindung liegt die Aufgabe zugrunde, das eingangs genannte Verfahren zu konzipieren, mit dem bei gleichzeitiger Einebnung mit gewünschtem Flankenwinkel eine gute Trennung der verschiedenen Strukturebenen erreicht wird. Demnach soll die aufzubringende Schicht in ihren Strukturkanten einen definierten Flankenwinkel und außerdem eine sehr glatte Strukturkante und -oberfläche aufweisen.

Diese Aufgabe wird dadurch gelöst, daß die strukturierten, vorzugsweise leitenden Oberflächen mit einem organischen Polymer, zum Beispiel Polyimid, und Fotolack überzogen werden. Die organischen Polymere müssen

a) in einem gewissen Bereich temperaturbeständig,

b) hoch vakuumbeständig,

c) elektrisch gut isolierend und

d) strukturierbar mittels einer Foto- und Ätztechnik sowohl über organische als auch über anorganische Ätzmasken sein.

Mit dem Verfahren nach der Erfindung wird eine gute Stufenbedeckung bei gleichzeitiger Einebnung erreicht.

Ausgestaltungen des erfindungsgemäßen Verfahrens sind Gegenstand der Unteransprüche.

Die Erfindung wird anhand der Figuren erläutert. Es zeigen:

Figur 1 eine Oberfläche mit Leiterbahnstrukturen,

Figur 2 Isolation der Leiterbahnstrukturen durch Polyimid,

Figur 2a die Darstellung nach Figur 2 mit Fotolack,

Figur 2b eine strukturierte Zwischenstufe,

Figur 2c strukturiertes Polyimid nach Entfernung des Fotolacks,

Figur 3 Aufbringen der anorganischen Ätzmaske,

Figur 4 strukturierte anorganische Ätzmaske,

Figur 5 Strukturieren von Polyimid mittels anorganischer Ätzmaske und Trockenätzung,

Figur 6 Einebnen der Leiterbahnstrukturen durch Fotolack,

Figur 7 Strukturieren des Fotolacks und

Figur 8 Tempern des Fotolacks.

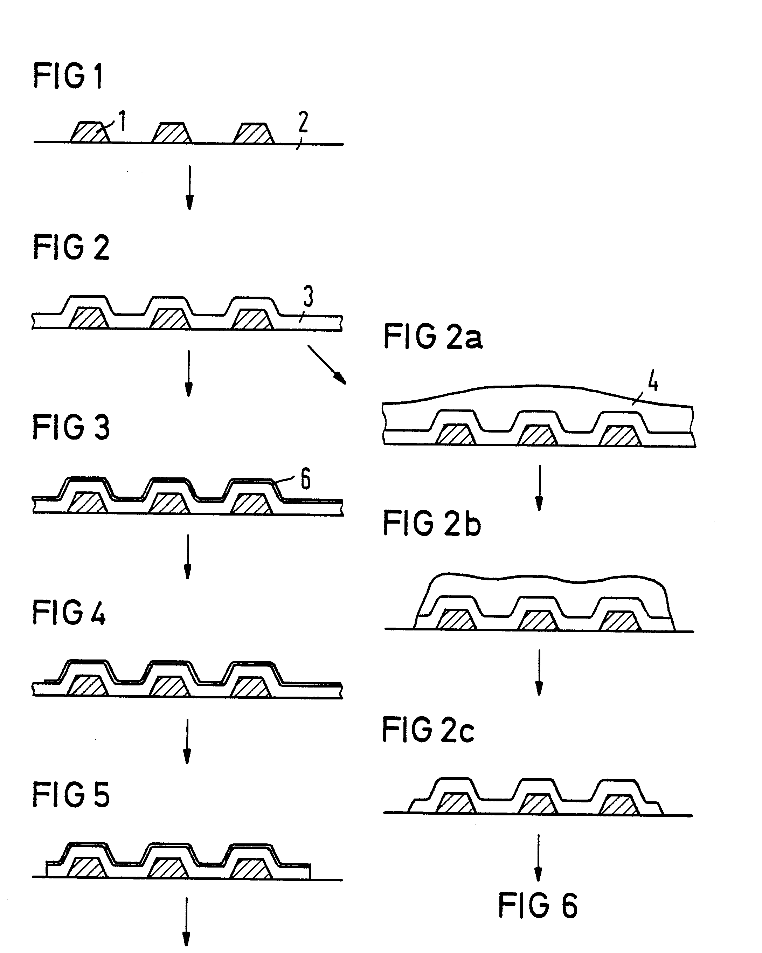

In der Figur 1 ist eine Schaltungsstruktur 1 auf einen Substrat 2 im Schnitt dargestellt. Diese Schaltungsstruktur kann zum Beispiel aus Spulen und Zuleitungen bestehen. Auf diese Schaltung wird - wie aus der Figur 2 zu erkennen ist - eine Isolation aus der Vorstufe eines Polyimids 3 aufgebracht. Nach diesem Schritt gibt es zwei Möglichkeiten, die in den Figuren 2a bis 2c bzw. 3 bis 5 dargestellt sind.

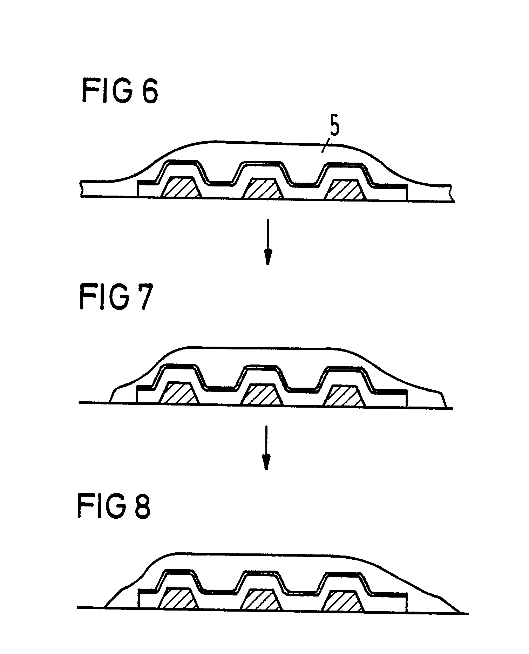

Nach der Darstellung in der Figur 2a wird die Schaltung nach der Figur 2 mit Fotolack 4 überzogen. Anschließend wird mit einer erforderlichen Maske belichtet und der Fotolack und das Polyimid an den belichteten Stellen mit einem Lösungsmittel entfernt. Dieser Zustand ist aus der Figur 2b ersichtlich. Daraufhin wird mit einem anderen Lösungsmittel, das die Polyimidvorstufe nicht angreift, der Fotolack entfernt. Im nächsten Verfahrensschritt wird die Polyimidvorstufe durch Temperaturbehandlung in die unlösliche Endstufe übergeführt. Daraufhin wird erneut Fotolack 5 aufgebracht, wie aus der Figur 6 zu ersehen ist. Der Fotolack ebnet verbliebene Strukturunebenheiten bis zum erforderlichen Grad ein. Die Strukturierung des Fotolacks (Figur 7) erfolgt in bezug zur vorher strukturierten Polyimid-Kante derart, daß die Polyimid-Kante in einem bestimmten Maß von Fotolack überdeckt wird. Durch anschliessendes Tempern (Figur 8) wird der Fotolack in eine beständige Polymerstufe übergeführt. Während dieses Tempervorgangs verfließt der Fotolack in einem definierten Ausmaß, unter anderem abhängig von

der Lackdicke,

Strukturaufbau und der Abstand der Polyimidkante zur Fotolackkante.

Es ergibt sich daraus ein ganz bestimmter Flankenwinkel. Außerdem sind die Strukturkanten und Oberflächen bedingt durch das Verfließen des Fotolacks sehr glatt.

Bei Beschreitung des angedeuteten zweiten Weges wird die Polyimidvorstufe nach der Figur 2 durch eine geeignete Temperaturbehandlung (Zyclisierung) in die Endstufe übergeführt. Das Polyimid zeichnet sich durch eine sehr gute Temperatur- und Hochvakuumbeständigkeit neben einer hohen Isolierfähigkeit aus. Die Stufenbedeckung von Strukturkanten ist dabei sehr gut.

Nach der Darstellung in der Figur 3 wird eine organische Ätzmaske 6, zum Beispiel SiO₂, auf die Strukturebene nach der Figur 2 aufgebracht. Nach Aufbringen von Fotolack, Belichten und Strukturieren des Fotolacks, Ätzen der anorganischen Maske, wird der Fotolack wieder entfernt (Figur 4). Anschließend erfolgt ein Trockenätzprozeß zum Strukturieren des Polyimids nach Figur 5. Daran schließen sich die bereits beschriebenen Verfahrensschritte nach den Figuren 6 bis 8 an.

Die Strukturierbarkeit von Polyimid ist sowohl über die Vorstufe mittels einer organischen Ätzmaske (Fotolack) (Figuren 2a bis c) und geeigneten Ätzlösungen, als auch über die Endstufe mittels einer anorganischen Ätzmaske (Figuren 3 bis 4) und einem Trockenätzverfahren möglich.

Mit dem Verfahren nach der Erfindung werden die vorteilhaften Eigenschaften von Fotolack und Polyimid vereint, um den gestellten Anforderungen zu genügen.

**Ansprüche**

1. Verfahren zur elektrischen Isolation und Einebnung von strukturierten, vorzugsweise leitenden Oberflächen, **dadurch gekennzeichnet**, daß die strukturierten Oberflächen (1) in einem zweistufigen Umhüllungsprozeß mit einem organischen Polymer (3), zum Beispiel Polyimid, und Fotolack (4) überzogen werden.

2. Verfahren nach Anspruch 1, **dadurch gekennzeichnet**, daß ganzflächig auf die Oberflächen die Vorstufe eines Polyimids (3) aufgebracht und ganzflächig mit Fotolack (4) überdeckt wird, daß der Fotolack und das Polyimid belichtet und strukturiert wird, anschließend der Fotolack entfernt und das Polyimid in die Endstufe überführt wird und erneut Fotolack (5) großflächig aufgetragen, strukturiert und getempert wird.

3. Verfahren nach Anspruch 1, **dadurch gekennzeichnet**, daß ganzflächig auf die Oberflächen die Vorstufe eines Polyimids (3) aufgebracht und getempert wird, daß anschließend eine anorganische Ätzmaske, zum Beispiel SiO₂, ganzflächig aufgebracht wird und nach Strukturieren dieser Ätzmaske Polyimid mittels eines Trockenätzverfahrens strukturiert wird, daß daraufhin erneut Fotolack (5) großflächig aufgetragen, strukturiert und getempert wird.

**FIG 1**

**FIG 2**

**FIG 2a**

**FIG 3**

**FIG 2b**

**FIG 4**

**FIG 2c**

**FIG 5**

**FIG 6**

FIG 6

5

FIG 7

FIG 8

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| Y | EP-A-0 122 631 (HITACHI) <br> * Figur 2; Ansprüche 1,4; Seite 14, Zeilen 1-5 * | 1 | H 01 L 21/90 <br> H 01 L 23/52 |
| Y | EP-A-0 026 967 (FUJITSU) <br> * Ansprüche 1-3,8 * | 1 | |
| A | | 2 | |
| A | EP-A-0 023 146 (FUJITSU) <br> * Ansprüche 1,16; Figur 3 * | 1,2 | |
| A | EP-A-0 103 879 (SIEMENS) <br> * Anspruch 1; Seite 2, Zeilen 23-31 * | 1-3 | |
| A | US-A-4 470 874 (IBM) <br> * Claim 1 * | 1 | RECHERCHIERTE SACHGEBIETE (Int. Cl.4) <br><br> H 01 L |
| P,X | EP-A-0 139 366 (TOSHIBA) <br> * Claims 1-4 * | 1 | |

Der vorliegende Recherchenbericht wurde für alle Patentansprüche erstellt.

| Recherchenort <br> DEN HAAG | Abschlußdatum der Recherche <br> 15-05-1986 | Prüfer <br> DE RAEVE R.A.L. |
|---|---|---|

KATEGORIE DER GENANNTEN DOKUMENTE
X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPA Form 1503 03 82